# FASCICULE DE BREVET EUROPEEN

(11) **EP 1 947 686 B1**
(45) Date de publication et mention de la délivrance du brevet: **19.06.2019**
(21) Numéro de dépôt: 08100640.5
(22) Date de dépôt: 18.01.2008
(51) Int. Cl.: H01L 21/336, H01L 21/84, H01L 27/12, H01L 21/8238, H01L 29/786

(54) **Dispositif à MOSFET sur SOI**
SOI-MOSFET Vorrichtung
Device with MOSFET on SOI

(30) Priorité: 19.01.2007 FR 0752776
(43) Date de publication de la demande: 23.07.2008
(73) Titulaire: Commissariat à l'Énergie Atomique et aux Énergies Alternatives, 75015 Paris (FR)
(72) Inventeur: Coronel, Philippe, 38530, BARRAUX (FR); Fenouillet-Beranger, Claire, 38100, GRENOBLE (FR)
(74) Mandataire: Ilgart, Jean-Christophe

(56) Documents cités:
- US-A1- 2002 063 286
- US-A1- 2002 105 039
- US-A1- 2005 082 531
- US-A1- 2006 231 873
- US-B1- 7 102 166
- ISABEL Y YANG ET AL: "Back-Gated CMOS on SOIAS For Dynamic Threshold Voltage Control" IEEE TRANSACTIONS ON ELECTRON DEVICES, IEEE SERVICE CENTER, PISACATAWAY, NJ, US, vol. 44, no. 5, mai 1997 (1997-05), XP011016162 ISSN: 0018-9383

## Description

### DOMAINE TECHNIQUE ET ART ANTÉRIEUR

L'invention concerne la réalisation d'un dispositif à MOSFET (« Metal-Oxide Semiconductor Field-Effect Transistor » en anglais, ou transistor à effet de champ de semi-conducteur d'oxyde de métal) sur SOI (« Silicon On Insulator » en anglais, ou silicium sur isolant).

Afin de satisfaire les prévisions de l'ITRS (« International Technology Roadmap for Semiconductors ») pour les générations futures de transistors, il est nécessaire de faire évoluer l'architecture des MOSFET.

L'ITRS indique que l'augmentation de la mobilité des porteurs dans le canal des transistors devient nécessaire pour maintenir l'accroissement des performances pour les générations de transistors dont les longueurs de grille sont inférieures à 100 nm.

Pour cela, il est par exemple possible d'utiliser des substrats à base de silicium contraint. Il est également possible d'utiliser des modules, ou couches internes aux dispositifs, qui, de par leur contrainte intrinsèque, viennent mettre en tension ou en compression le transistor.

Les documents « High Performance CMOS Fabricated on Hybrid Substrate With Différent Crystal Orientations » de M. Yang et al, Electron Devices Meeting 2003 Technical Digest. IEEE International, du 8 au 10 décembre 2003, pages 18.7.1 à 18.7.4, et « On the Integration of CMOS with Hybrid Crystal Orientations », de M. Yang et al, 2004 Symposium on VLSI Technology, Digest of Technical Papers, du 15 au 17 juin 2004, pages 160 à 161, décrivent un dispositif réalisé sur un substrat de silicium à orientations cristallines hybrides, c'est-à-dire comportant un transistor NMOS réalisé sur une partie du substrat dont l'orientation cristalline est (100) et un transistor PMOS sur une partie du substrat dont l'orientation cristalline est (110). La partie du substrat sur laquelle est réalisé un des deux transistors est de type SOI, l'autre partie du substrat sur laquelle est réalisé l'autre des deux transistors étant de type bulk. Ce type de structure permet également d'augmenter la mobilité des porteurs dans le canal des transistors. Ce type de dispositif a notamment pour inconvénient que les deux transistors ont des propriétés et des fonctionnements très différents. De plus, l'avantage d'un substrat SOI par rapport à un substrat de type bulk ne peut être obtenu que pour l'un des deux transistors. Enfin, il n'est pas possible d'avoir une commande arrière, ou « ground plane », pour le transistor se trouvant sur la partie SOI car celle-ci affecterait le comportement du transistor se trouvant sur la partie bulk du substrat.

Le document « Back-Gated CMOS on SOIAS for dynamic threshold voltage control » de I.Y. Yang et al., IEEE Trans on Elec Devices, vol 44, n°5, Mai 1997, pages 822 à 831, décrit un dispositif CMOS sur SOI de type double grille avec connexion des grilles, ou commandes, arrières. L'épaisseur de l'oxyde enterré est supérieure à 65 nm et celle du silicium est supérieure à 40 nm. Les commandes arrières sont réalisées par implantation, ce qui implique un dopage des canaux du dispositif CMOS, venant perturber le fonctionnement de ces canaux (ajustement des tensions de seuil complexifié). Les charges placées dans le diélectrique suite à l'implantation vont également modifier les effets de couplage électrostatique, ce qui aura un impact sur les effets de canal court de ce dispositif CMOS. De plus, les zones dopées des commandes arrières s'étendent uniquement sous les zones actives des transistors, rendant la connexion de ces commandes arrières complexe.

Le document « 65nm High Performance SRAM Technology with 25F2, 0.16µm2 S3 (Stacked Single-crystal Si) SRAM Cell, and Stacked Peripheral SSTFT for Ultra High Density and High Speed Applications » de Hoon Lim et al., Proceedings of ESSDERC, 2005, pages 549 à 552, décrit une architecture comportant des transistors MOS empilés les uns sur les autres sur trois niveaux. Ce type d'architecture permet de gagner en densité d'intégration des transistors (moins de place occupée), mais ce gain implique une plus grande complexité du procédé pour réaliser une telle structure (multiplication des étapes de photolithographie nécessaires à la réalisation des grilles des transistors). De plus, les transistors empilés du dispositif SOI ne sont pas optimisés car leur couche d'oxyde enterré est épaisse et il n'est pas possible d'améliorer les performances par une commande arrière. L'orientation cristalline optimale pour ce dispositif n'est également réalisable que par collage. Enfin, le silicium polycristallin déposé doit être recristallisé, impliquant un long budget thermique à basse température ou plusieurs étapes de collage, augmentant le coût de réalisation de ce dispositif.

Le document US 2005/0082531 A1 décrit un dispositif à MOSFET sur SOI comprenant une région supérieure comportant un premier dispositif semi-conducteur de type MOSFET réalisé sur une première couche de semi-conducteur empilée sur une première couche diélectrique et une première portion d'une seconde couche de semi-conducteur, et une région inférieure comportant un second dispositif semi-conducteur de type MOSFET disposé sur une seconde portion de la seconde couche de semi-conducteur, une grille du second dispositif étant formée par une portion métallique, la seconde couche de semi-conducteur étant disposée sur une seconde couche isolante.

Le document US 2006/231873 A1 décrit un dispositif à MOSFET sur SOI, comprenant un dispositif semi-conducteur de type MOSFET réalisé sur une première couche de semi-conducteur empilée sur une première couche diélectrique, une deuxième couche semi-conductrice formant une grille arrière, une seconde couche diélectrique et une troisième couche de semi-conducteur.

### EXPOSÉ DE L'INVENTION

Un but de la présente invention est de proposer un dispositif à MOSFET permettant d'obtenir de bonnes performances en terme de flexibilité pour optimiser les performances des NMOS et PMOS indépendamment l'un de l'autre, en fonctionnement dynamique du circuit, conservant un bon contrôle électrostatique, c'est-à-dire limitant les effets de canal court sur la tension de seuil, permettant une commande arrière de canal pour pouvoir réaliser de multiples Vth, et pouvant intégrer des dispositifs semi-conducteurs de type différent et aussi des circuits avec des fonctionnalités différentes sur un même substrat.

Pour cela, la présente invention propose un dispositif à MOSFET sur SOI, selon la revendication indépendante 1, comprenant :
- une région supérieure comportant au moins un premier dispositif semi-conducteur de type MOSFET disposé dans une première couche de semi-conducteur empilée sur une première couche isolante, une première portion d'une première couche métallique et une première portion d'une seconde couche de semi-conducteur,
- une région inférieure comportant au moins un second dispositif semi-conducteur de type MOSFET disposé dans une seconde portion de la seconde couche de semi-conducteur, une grille du second dispositif semi-conducteur étant formée par au moins une seconde portion de la première couche métallique.
la seconde couche de semi-conducteur étant disposée sur une seconde couche isolante empilée sur une seconde couche métallique.

La première couche de semi-conducteur et la première couche diélectrique peuvent former un substrat SOI pour le premier dispositif semi-conducteur, la seconde portion de la seconde couche de semi-conducteur et la seconde couche diélectrique pouvant former un autre substrat SOI pour le second dispositif semi-conducteur.

Ainsi, chacun des dispositifs semi-conducteurs est réalisé sur un substrat semi-conducteur sur isolant différent, permettant à chaque dispositif et chaque substrat d'avoir ses propres caractéristiques. Les dispositifs semi-conducteurs de type MOSFET sont intégrés sur deux niveaux différents, réalisant une intégration « en trois dimensions » non empilée, les dispositifs semi-conducteurs n'étant pas superposés l'un au-dessus de l'autre.

L'un des premier ou second dispositifs semi-conducteurs de type MOSFET peut comporter, ou être, un transistor PMOS et l'autre des premier ou second dispositifs semi-conducteurs de type MOSFET peut comporter, ou être, un transistor NMOS.

De plus, les deux dispositifs semi-conducteurs ont chacun une commande arrière, ou « ground plane », formée respectivement par la première couche métallique et la seconde couche métallique, ou par la première portion de la première couche métallique et la seconde couche métallique lorsque la grille du second dispositif semi-conducteur est formée par une seconde portion de la première couche métallique, pouvant être intégrée et contactée complètement indépendamment grâce à une intégration sur deux niveaux. La tension appliquée à l'une et/ou l'autre des deux commandes arrières peut être nulle, ou non si on veut réaliser un contrôle arrière des dispositifs semi-conducteurs.

On peut ainsi obtenir des dispositifs à doubles grilles indépendantes.

De plus, la structure proposée peut également comporter un couplage, ou connexion, entre les commandes arrières des deux dispositifs semi-conducteurs, en réalisant par exemple un couplage électrique entre la première couche métallique (ou la première portion de la première couche métallique) et la seconde couche métallique, ou en couplant la première couche métallique et la seconde couche métallique à un premier contact électrique, la seconde couche métallique pouvant également être couplée à un second contact électrique. Cette variante est particulièrement intéressante lorsque ces deux dispositifs sont destinés à être utilisés pour réaliser des circuits de type SRAM, NAND ou encore NOR.

La première couche métallique, ou la première portion de la première couche métallique, peut être de type P lorsque le premier dispositif semi-conducteur comporte ou est un transistor NMOS, ou de type N lorsque le premier dispositif semi-conducteur comporte ou est un transistor PMOS, ou encore de type « midgap », c'est-à-dire dont le travail de sortie soit compris entre environ 4,17 eV et 5,1 eV, ou entre 4,55 eV et 4,65 eV. La seconde couche métallique peut être de type P lorsque le second dispositif semi-conducteur comporte ou est un transistor NMOS ou de type N lorsque le second dispositif semi-conducteur comporte ou est un transistor PMOS. Cette configuration permet d'empêcher une forte dégradation du DIBL (« Drain Inducted Barrier Lowering » en anglais, ou abaissement de barrière induit par le drain) du transistor et de la pente sous le seuil, lorsque la longueur de grille diminue.

L'épaisseur de la première couche diélectrique et/ou de la seconde couche diélectrique peut être inférieure ou égale à environ 20 nm. Ainsi, la couche mince diélectrique d'un substrat SOI (ou BOX pour « Buried Oxide » en anglais, c'est-à-dire oxyde enterré) permet la réalisation d'un dispositif de type MOSFET à déplétion totale (« fully-depleted » en anglais) pleinement efficace, la commande arrière de ce dispositif limitant l'extension de la zone de charge d'espace sous le canal et donc contribuant à réduire les effets de canal court, notamment dans le cas d'un canal faiblement dopé ou non dopé, ou lorsque la grille du dispositif MOSFET est à base de métal et/ou est siliciurée. A faible dopage de canal, l'utilisation d'une commande arrière permet de gagner un facteur 2 sur le DIBL du transistor, c'est-à-dire d'avoir un DIBL réduit d'environ 100 mV par rapport au DIBL d'un transistor à faible dopage de canal sans commande arrière.

De préférence, les canaux des dispositifs semi-conducteurs de type MOSFET peuvent être non dopés.

Le dispositif peut comporter au moins une région diélectrique ou isolante séparant latéralement ladite région supérieure de ladite région inférieure.

La première et/ou la seconde couche de semi-conducteur peut être à base de silicium, et/ou de silicium contraint, et/ou de silicium-germanium, et/ou de Germanium, et/ou de tout autre matériau de type III-V.

Le semi-conducteur de la première couche de semi-conducteur peut avoir une orientation cristalline différente de celle du semi-conducteur de la seconde couche de semi-conducteur. Par exemple, le semi-conducteur de l'une de la première ou de la seconde couche de semi-conducteur peut avoir une orientation cristalline égale à (100) et le semi-conducteur de l'autre de la première ou de la seconde couche peut avoir une orientation cristalline égale à *(110)*.

La présente invention permet donc :
- de réaliser des transistors NMOS et PMOS sur SOI avec des orientations cristallines différentes adéquates,
- de réaliser des transistors NMOS et PMOS ou un circuit avec des fonctions logiques sur un même niveau et de réaliser d'autres fonctions avec des matériaux différents sur un autre niveau,
- d'obtenir, en terme de fonctions logiques, des intégrations horizontales et verticales,
- d'obtenir des transistors à multiples tensions de seuil, en jouant sur les épaisseurs des couches diélectriques des substrats SOI, sur la nature et le travail de sorti des commandes arrières qui va moduler les tensions de seuil du PMOS et du NMOS,
- d'obtenir des transistors NMOS et PMOS à commandes arrières indépendantes ou reliées électriquement entre elles.

La première couche métallique peut être couplée à un premier contact électrique, la seconde couche métallique pouvant être couplée à un second contact électrique indépendant du premier contact électrique.

Une grille du premier dispositif semi-conducteur peut être à base d'un matériau différent du métal de la seconde couche métallique.

Une grille du premier dispositif semi-conducteur peut être disposée sur une portion de diélectrique à forte permittivité (High-K), par exemple un diélectrique dont la permittivité est supérieure à environ 3,9, la grille du second dispositif semi-conducteur pouvant être disposée sur un empilement de type oxyde-nitrure-oxyde (également appelé empilement ONO, formé par une couche de nitrure disposée entre deux couches d'oxyde.

La première couche diélectrique peut être disposée sur une première portion de la première couche métallique, la portion métallique pouvant être formée par une seconde portion de la première couche métallique.

La présente invention concerne également un procédé de réalisation d'un dispositif à MOSFET sur SOI, selon la revendication indépendante 14, comprenant au moins les étapes de :
a) réalisation d'une structure formée d'une première couche de semi-conducteur empilée sur une première couche isolante, une première couche métallique, une seconde couche de semi-conducteur, une seconde couche isolante et une seconde couche métallique, et avec une troisième couche diélectrique disposée entre la première couche métallique et la seconde couche de semi-conducteur,
b) gravure d'une partie d'au moins la première couche de semi-conducteur et la première couche isolante, mettant à nu une partie de la première couche métallique et définissant des régions supérieure et inférieure du dispositif à MOSFET sur SOI,
c) dépôt d'une quatrième couche diélectrique et d'un matériau de grille sur une partie non gravée de la première couche de semi-conducteur au niveau de la partie supérieure du dispositif à MOSFET sur SOI,
d) gravure du matériau de grille, de la première couche métallique, et des troisième et quatrième couches diélectriques, formant les grilles et les diélectriques de grille d'un premier et d'un second dispositif semi-conducteur de type MOSFET respectivement au niveau des régions supérieure et inférieure,
e) réalisation des zones de source et de drain des premier et second dispositifs semi-conducteurs de type MOSFET, respectivement au niveau des régions supérieure et inférieure.

Le procédé peut comporter en outre, après l'étape e), une étape de réalisation d'un premier contact électrique couplé à la première couche métallique et d'un second contact électrique couplé à la seconde couche métallique, les deux contacts électriques pouvant être indépendants l'un de l'autre.

Dans une variante, le procédé peut comporter en outre, après l'étape e), une étape de réalisation d'un premier contact électrique couplé à la première couche métallique et à la seconde couche métallique, et d'un second contact électrique couplé à la seconde couche métallique.

Le procédé peut également comporter en outre, après l'étape e), une étape de réalisation d'une région diélectrique ou isolante séparant latéralement la région supérieure de la région inférieure.

Les contacts électriques couplés aux couches métalliques formant les commandes arrières des dispositifs semi-conducteurs sont réalisés après la formation des dispositifs semi-conducteurs, une fois pour tout le circuit ou en utilisant une zone de STI (« Shallow Trench Isolation » en anglais, ou tranches d'isolation de surface) les contacts électriques passant à travers cette zone de STI sans créer de courts-circuits.

La réalisation de l'étape a) peut comporter la formation, par implantation d'ions et cuisson, dans la seconde couche à base de semi-conducteur, de zones définissant les portions de la seconde couche de semi-conducteur et pouvant être gravées sélectivement par rapport au semi-conducteur de ladite seconde couche, et pouvant comporter en outre, après l'étape d), une étape de gravure sélective de ces zones.

Avec ce procédé, il est possible de réaliser des grilles de dispositifs de type MOSFET, par exemples à base de matériaux différents ou non, en mettant en oeuvre une seule étape de lithographie de grille, contrairement aux procédés de réalisation de dispositifs double grille de l'art antérieur. Les tensions de seuil pourront aussi être ajustées par l'utilisation de la polarisation indépendante des deux régions de commande arrière ou par le dopage ou le travail de sorti de la commande arrière.

Une co-intégration de dispositifs à déplétion partielle et à déplétion totale peut être réalisée sans nécessité d'épitaxie ou d'amincissement des couches semi-conductrices.

Selon le procédé décrit, on peut réaliser une grille pour le second dispositif semi-conducteur de type MOSFET et une commande arrière pour le premier dispositif semi-conducteur de type MOSFET à partir d'une même couche métallique.

La mise en oeuvre de l'étape b) peut comporter également la gravure de la première couche métallique et de la seconde couche de semi-conducteur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un dispositif à MOSFET sur SOI, objet de la présente invention, selon un mode de réalisation particulier,
- les figures 2A à 2F représentent les différentes étapes d'un procédé de réalisation d'un dispositif MOSFET sur SOI, objet de la présente invention, selon un premier mode de réalisation,
- les figures 3A à 3B représentent des étapes d'un procédé de réalisation d'un dispositif MOSFET sur SOI, objet de la présente invention, selon un second mode de réalisation,
- la figure 4 représente une étape d'un procédé de réalisation d'un dispositif MOSFET sur SOI, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

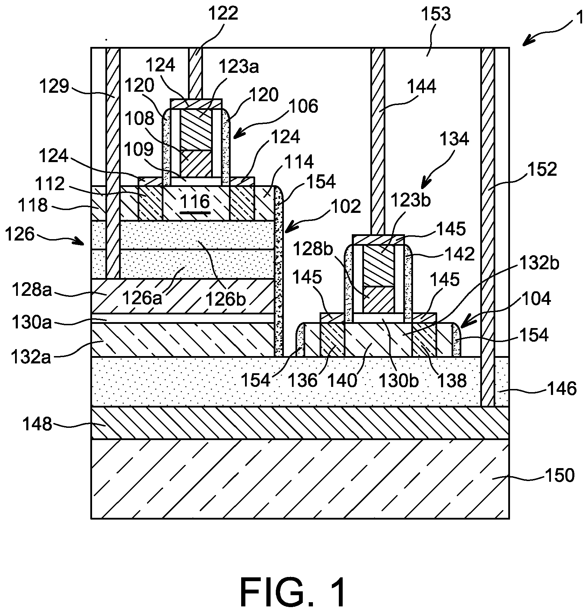

On se réfère tout d'abord à la figure 1 qui représente un dispositif à MOSFET sur SOI 1 selon un mode de réalisation particulier.

Ce dispositif 1 comporte deux régions 102 et 104 comportant chacune respectivement un dispositif semi-conducteur de type MOSFET.

La région supérieure 102 comporte un transistor 106 de type PMOS formé par une grille 108, un diélectrique de grille 109, des zones de source et de drain, respectivement 112, 114 et un canal 116 réalisées dans une couche à base de semi-conducteur 118. Des espaceurs 120 sont également réalisés sur les côtés de la grille 108. La grille 108 est couplée à un contact de grille 122, par lequel une tension de commande est appliquée à la grille 108.

La grille 108 est à base de métal, par exemple à base de molybdène et/ou de tungstène. Dans une variante, la grille pourrait être à base de polysilicium. La couche diélectrique 109 est à base d'un matériau de préférence à forte permittivité (diélectrique High-K), c'est-à-dire de constante diélectrique supérieure ou égale à environ 3,9, tel que par exemple du silicate d'hafnium ou de l'oxyde d'hafnium, et d'une épaisseur par exemple égale à environ 3 nm. La couche de semi-conducteur 118 est par exemple une couche de silicium, d'une épaisseur par exemple égale à environ 10 nm. Une portion 123a d'une couche de polysilicium est ici disposée sur la grille métallique 108, par exemple d'une épaisseur comprise entre environ 50 nm et 100 nm. Dans ce mode de réalisation, la grille 108 est également siliciurée par une couche de siliciure 124 disposée sur la portion de polysilicium 123a, recouvrant également les zones de source et de drain 112, 114, par exemple à base de siliciure de nickel ou siliciure de cobalt, obtenue par dépôt de métal et recuit. Cette couche de siliciure 124 permet d'améliorer le contact avec la grille 108 et les zones de source et drain 112, 114 en diminuant les résistances de contact. La couche 118 est ici à base de silicium d'orientation cristalline *(110),* permettant ainsi d'augmenter la mobilité des trous. La couche 118 peut également être à base de silicium contraint, permettant d'augmenter la mobilité des porteurs et donc d'augmenter les performances en courant du transistor.

La couche de silicium 118 repose sur une couche diélectrique ou isolante 126, par exemple à base d'oxyde de silicium. Dans ce mode de réalisation, la couche diélectrique 126 est formée de deux sous-couches 126a, 126b collées entre elles par collage moléculaire. L'épaisseur de la couche diélectrique 126 est par exemple d'environ 20 nm. Typiquement, la couche diélectrique 126 aura une épaisseur inférieure ou égale à environ 20 nm.

Ainsi, la couche de silicium 118 et la couche diélectrique 126 forment un substrat SOI pour le PMOS 126. Compte tenu de l'épaisseur de 10 nm de la couche de silicium 118 et de l'épaisseur de 20 nm de la couche diélectrique 126, le PMOS 106 est donc ici à déplétion totale.

Une portion 128a d'une couche métallique 128, par exemple à base de nitrure de titane et d'une épaisseur égale à environ 10 nm, disposée sous la couche diélectrique 126, sert de commande arrière au PMOS 106, permettant d'agir sur le potentiel et la déplétion dans le canal 116, et donc modifiant la tension de seuil du PMOS 106. Cette portion 128a est couplée à un contact métallique 129 par lequel une tension de commande arrière est appliquée à la portion métallique 128a. La couche métallique 128 pourrait également être réalisée à base de carbure de tantale, ou encore à base de polysilicium.

Enfin, la portion 128a de couche métallique repose sur une portion 130a d'une couche d'oxyde 130, par exemple à base d'un matériau de préférence à forte permittivité, c'est-à-dire de constante diélectrique supérieure à environ 3,9, tel que du silicate d'hafnium ou de l'oxyde d'hafnium et d'une épaisseur égale à environ 3 nm, et sur une portion 132a d'une couche de semi-conducteur 132, par exemple à base silicium, d'une épaisseur égale à environ 10 nm, et d'orientation cristalline *(100).* Il est également possible que la couche d'oxyde 130 soit remplacée par un empilement ONO, c'est-à-dire une couche de nitrure disposée entre deux couches d'oxyde. Dans une variante de ce mode de réalisation, la couche de semi-conducteur 118 pourrait avoir une orientation cristalline *(100)* et la couche de semi-conducteur 132 une orientation cristalline *(110),* augmentant ainsi la mobilité des trous et donc les performance du PMOS 106. Mais les orientations cristallines de ces deux couches 118, 132 à base de semi-conducteur pourraient également être différentes de ces deux exemples d'orientation cristalline.

La région inférieure 104 comporte un transistor 134 de type NMOS. Le NMOS 134 comporte une grille 128b. Cette grille 128b est une autre portion de la couche métallique 128, c'est-à-dire à base de nitrure de titane et d'une épaisseur égale à environ 10 nm. Le NMOS 134 comporte également un diélectrique de grille formé en partie par une autre portion 130b de la couche diélectrique ou de l'empilement ONO 130, des zones de source et de drain, respectivement 136 et 138, et un canal 140 réalisées dans une autre portion 132b de la couche de silicium 132. Etant donné que la couche de silicium 132 est à base de silicium d'orientation cristalline *(100),* on augmente la mobilité des électrons et améliore donc les performances en courant du transistor NMOS 134.

Des espaceurs 142 sont également réalisés sur les côtés de la grille 128b, ainsi que des espaceurs 154 permettant d'isoler les couches à base de semi-conducteur.

La grille 128b est couplée à un contact de grille 144, acheminant la tension de commande à la grille 144. Dans ce mode de réalisation, la grille 128b est également recouverte d'une portion 123b d'une couche de polysilicium et siliciurée par une couche de siliciure 145, recouvrant également les zones de source et de drain 136, 138, par exemple à base de siliciure de nickel ou siliciure de cobalt, obtenue par dépôt de métal et recuit. Cette couche de siliciure 145 permet d'améliorer le contact avec la grille 128b et les zones de source et drain 136, 138 en diminuant les résistances de contact. Dans une variante, la grille du NMOS 104 peut également comporter, outre la portion 128b de la couche métallique 128, une portion du matériau formant la grille 108 disposée entre la portion 128b de la couche métallique 128 et la portion de polysilicium 123b.

Les régions inférieure 104 et supérieure 102 sont disposées sur une couche diélectrique 146, par exemple à base d'oxyde de silicium et d'une épaisseur inférieure ou égale à environ 20 nm.

Ainsi, la portion 132b de la couche de silicium 132 et la couche diélectrique 146 forment un substrat SOI pour le NMOS 134. De part les épaisseurs de la couche de silicium 132 et de la couche diélectrique 146, le NMOS 134 forme ici un transistor à déplétion totale, permettant de mieux contrôler les effets de canal court. De plus, le canal 140 du NMOS est ici non dopé, ce qui permet de travailler à un champ effectif plus faible et donc d'avoir une mobilité non dégradée par un dopage de canal, augmentant ainsi les performances des dispositifs.

La couche diélectrique 146 est disposée sur une couche métallique 148, par exemple à base de nitrure de titane et d'une épaisseur égale à environ 10 nm, elle-même disposée sur un substrat 150 à base de semi-conducteur tel que du silicium. Cette couche métallique 148 est couplée à un contact 152 permettant de réaliser une commande arrière du NMOS 134.

Les contacts électriques de commandes arrières 129 et 152 sont ici indépendants l'un de l'autre, la commande arrière étant donc indépendante pour le PMOS 106 et le NMOS 134.

Enfin, une couche d'oxyde 153 est déposée sur l'ensemble du dispositif 1, réalisant une isolation globale des couches formant le dispositif 1.

Lorsque la portion diélectrique 109 est à base d'un diélectrique High-K et que la portion diélectrique 130b est formée d'un empilement ONO, le dispositif 1 est particulièrement adapté pour former un dispositif mémoire logique.

Dans une variante du dispositif 1 représenté sur la figure 1, il est possible que le contact électrique 129 soit couplé à la fois à la portion 128a de la couche métallique 128 et à la seconde couche métallique 148 en se prolongeant à travers les portions 130b et 132a et la couche diélectrique 146. On réalise ainsi des commandes arrières couplées entre elles, ce qui s'applique particulièrement à des circuits de type SRAM, NAND ou NOR où les dépendances entre les dispositifs sont utiles pour réduire la variabilité au niveau des commandes arrières.

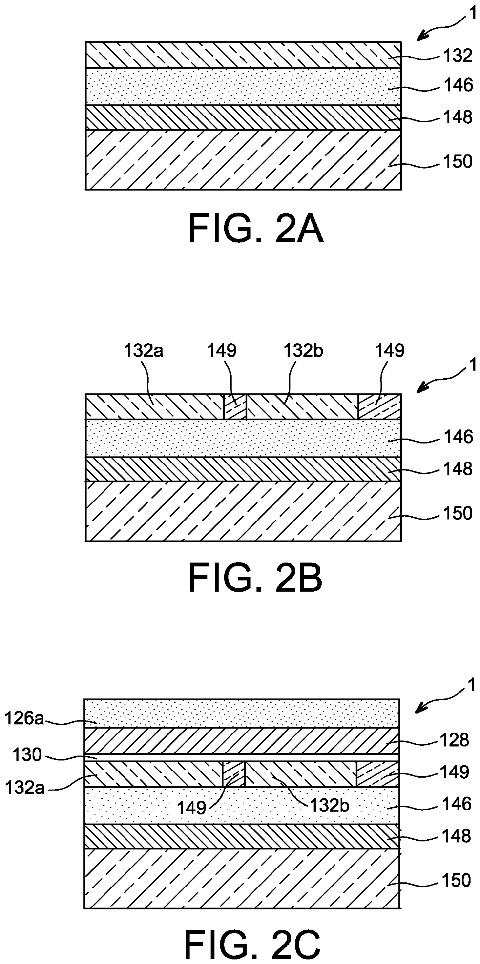

Un procédé de réalisation du dispositif à MOSFET sur SOI 1 selon un premier mode de réalisation va maintenant être décrit en liaison avec les figures 2A à 2F.

Comme représenté sur la figure 2A, on réalise tout d'abord une structure comportant le substrat 150 à base de semi-conducteur sur laquelle est empilée la couche métallique 148, la couche diélectrique 146 et la couche de silicium 132 d'orientation cristalline *(100).*

On réalise ensuite dans la couche de silicium 132 des zones 149 de silicium-germanium. Ces zones 149 sont crées par photolithographie, puis par implantation de germanium dans la seconde couche de silicium 132 aux emplacements de ces zones 149. Un recuit transforme ensuite le silicium dans lequel est implanté le germanium en silicium-germanium, formant les zones 149. Sur la figure 2B, la couche de silicium 132 ainsi divisée en deux portions 132a et 132b, les zones 149 de silicium-germanium séparant les portions 132a, 132b de silicium. De manière générale, les zones 149 peuvent également être réalisées à partir d'au moins un matériau pouvant être retiré sélectivement par rapport au matériau de la couche 132, tel que du bore, du phosphore, de l'aluminium, ou oxyde, par exemple en réalisant un dopage en phase vapeur (VPD ou « Vapor Phase Doping » en anglais) pour former les zones 149.

Comme représenté sur la figure 2C, on dépose ensuite, sur la couche de silicium 132, la couche diélectrique 130, sur laquelle est déposée la couche métallique 128 et la sous-couche diélectrique 126a.

On réalise ensuite un collage moléculaire entre la première structure précédemment réalisée et une seconde structure formée d'un empilement double SOI comportant une première sous-couche diélectrique 126b, par exemple d'une épaisseur égale à environ 10 nm, de la couche de silicium 118, d'une couche diélectrique 156, par exemple à base d'oxyde de silicium et d'une épaisseur égale à environ 145 nm, et une autre couche de silicium 158, par exemple similaire à la couche de silicium 150. Le collage moléculaire est réalisé entre les deux sous-couches 126a, 126b formant ainsi une couche diélectrique 126 d'épaisseur égale à environ 20 nm.

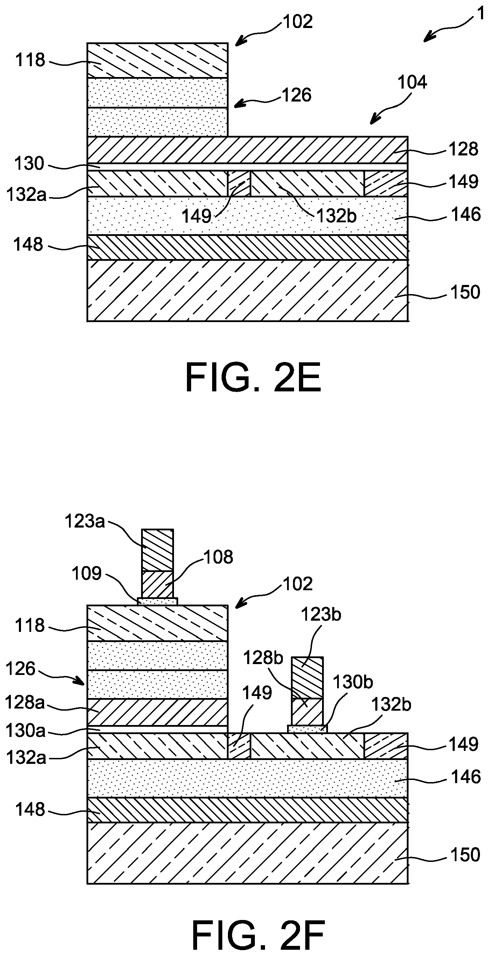

Comme représenté sur la figure 2E, on retire la couche de silicium 158 et la couche d'oxyde 156, puis on réalise une photolithographie et une gravure pour définir les zones actives sur lesquelles seront réalisés les transistors NMOS et PMOS. La gravure est stoppée au niveau de la couche métallique 128. Ainsi, on définit les régions supérieure 102 et inférieure 104 du dispositif 1.

On réalise ensuite le dépôt de la couche de diélectrique 109, de métal ou de polysilicium pour la réalisation de la grille 108 et d'une couche de polysilicium pour former les portions 123a et 123b disposées sur les grilles 108 et 128b. Une photolithographie et une gravure du métal 108 et de la couche métallique, 128 ainsi que des couches diélectriques 109 et 130 et de la couche de polysilicium permettront de former la grille métallique 108 pour la réalisation du PMOS 106 et la grille métallique 128b du NMOS 134 (figure 2F). Dans une variante, il est possible de conserver une portion de la couche diélectrique 109 sur la grille métallique 128b. Les matériaux des grilles 128b et 108 peuvent être de même nature ou de nature différentes, formant alors des grilles duales permettant d'ajuster la tension de seuil pour le NMOS 134 et le PMOS 106.

On réalise alors les zones de sources 112, 136 et de drain 114, 138 dans le silicium 118 et 132b. On retire ensuite, de manière sélective par rapport au silicium de la couche 132, les zones 149 de silicium-germanium. Une épitaxie supplémentaire peut également être réalisée afin de surélever les zones de source 112, 136 et de drain 114, 138, facilitant la formation ultérieure de couches de siliciure 124 et 145 sur ces zones de source et de drain. On réalise ensuite les espaceurs 120, 142 et 154, isolant les grilles et les régions supérieure 102 et inférieure 104, et on forme une couche de siliciure 124 et 145 sur les portions de polysilicium 123a et 123b, ainsi que sur les zones de source et de drain. La couche d'oxyde 153 est alors déposée sur l'ensemble du dispositif 1. Enfin, les contacts 129, 122, 144 et 152, venant se coupler aux grilles 108 et 128b et aux commandes arrières formées par la portion 128a de couche métalliques pour le PMOS 106 et par la couche métallique 148 pour le NMOS 134, sont réalisés par une gravure dans la couche d'oxyde, dépôt dans ces gravures d'une barrière d'isolation, par exemple à base de nitrure de titane et/ou de nitrure de tantale, puis par un dépôt d'un métal tel que du tungstène dans les gravures réalisées (voir figure 1).

Dans une variante du procédé précédemment décrit, variante ne faisant pas partie de la présente invention, on peut, lors de l'étape de gravure représentée à la figure 2E, stopper la gravure sur la couche diélectrique 130, retirant ainsi la portion de la couche métallique 128 se trouvant au niveau de la région inférieure 104. Le matériau de grille peut alors être déposé à la fois au niveau de la région supérieure 102 et au niveau de la région inférieure 104. L'étape de photolithographie et de gravure réalisée ensuite peut alors former les deux grilles 108 et 128b. Les deux grilles sont donc ici formées à partir d'une même couche de matériau de grille.

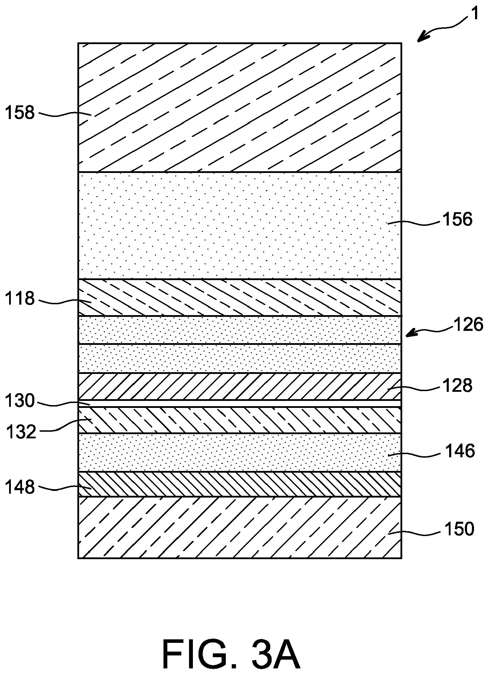

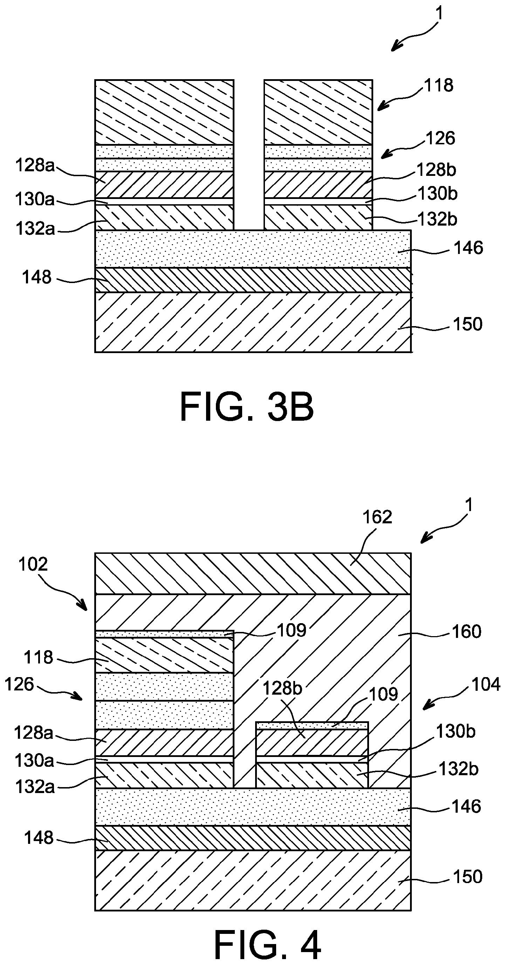

Un procédé de réalisation du dispositif à MOSFET sur SOI 1 selon un second mode de réalisation va maintenant être partiellement décrit en liaison avec les figures 3A et 3B.

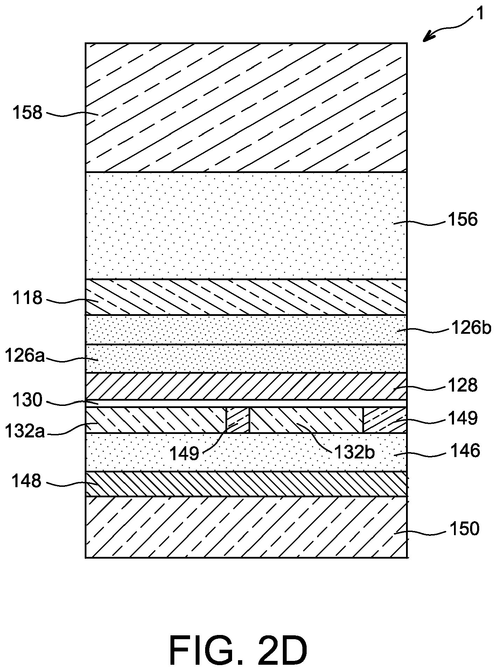

Comme représenté sur la figure 3A on réalise tout d'abord un empilement de couches comportant les mêmes couches que l'empilement représenté sur la figure 2D. Par rapport à la couche de silicium 132 de la figure 2D, la couche de silicium 132 représentée sur la figure 3A ne comporte pas les zones de silicium-germanium 149. Cet empilement de couches peut par exemple être réalisé par des techniques similaires à celles utilisées pour la réalisation de l'empilement représenté sur la figure 2D.

On retire tout d'abord les couches 158 et 156, puis on réalise ensuite une photolithographie et une gravure de l'ensemble des couches 118, 126, 128, 130 et 132 en s'arrêtant à la couche diélectrique 146, en séparant ces couches en portions formant les futures régions supérieures 102 et inférieure 104 (figure 3B).

Ensuite, on retire le silicium 118 et la partie de la couche diélectrique 126 se trouvant au niveau de la région inférieure 104. On vient ensuite déposer le diélectrique 109 puis le métal 108 de la grille du PMOS 106. On vient alors réaliser la gravure de la grille 108. Le procédé est ensuite terminé comme précédemment pour le premier mode de réalisation comme représenté sur la figure 2F, et aboutissant au dispositif 1 de la figure 1.

Un procédé de réalisation d'un dispositif à MOSFET sur SOI 1 selon un troisième mode de réalisation va maintenant être partiellement décrit en liaison avec la figure 4.

On réalise tout d'abord un empilement de couches comportant les mêmes couches que l'empilement représenté sur la figure 3A. Cet empilement de couches peut par exemple être réalisé par des techniques similaires à celles utilisées pour la réalisation des empilements représentés sur les figures 2D et 3A.

On retire ensuite les couches 158 et 156, puis on réalise ensuite une photolithographie et une gravure de l'ensemble des couches 118, 126, 128, 130 et 132 en s'arrêtant à la couche diélectrique 146, en séparant ces couches en portions formant les futures régions supérieures 102 et inférieure 104, de manière similaire à la figure 3B.

On retire ensuite les portions des couches semi-conductrice 118 et diélectrique 126 au niveau de la région inférieure 104. On dépose alors la couche diélectrique 109 sur la portion restante de la couche 118 se trouvant au niveau de la portion supérieure 106 et sur la portion 128b de la première couche métallique 128, puis une couche de métal 160 et une couche de polysilicium 162 sur l'ensemble de la structure (figure 4).

Enfin, on réalise une gravure de la couche de polysilicium 162 et de la couche métallique 160 telle qu'il ne reste qu'une portion des couches métalliques 160 et de polysilicium 162 au niveau d'une partie de la couche diélectrique 109 présente au niveau des zones inférieure 104 et supérieure 106. Le dispositif 1 est ensuite achevé de manière similaire au dispositif aux modes de réalisation décrits précédemment.

La présente invention s'applique à tous les noeuds technologiques de réalisation de dispositifs semi-conducteurs, et particulièrement aux noeuds technologiques inférieur à 100 nm.

## Revendications

1. Dispositif (1) à MOSFET (106, 134) sur SOI, comprenant :
- une région supérieure (102) comportant au moins un premier dispositif semi-conducteur (106) de type MOSFET réalisé dans une première couche de semi-conducteur (118) empilée sur une première couche diélectrique (126), une première portion (128a) d'une première couche métallique (128) et une première portion (132a) d'une seconde couche de semi-conducteur (132), et avec un diélectrique de grille (109) et un matériau de grille (108) sur la première couche de semi-conducteur (118),
- une région inférieure (104) comportant au moins un second dispositif semi-conducteur (134) de type MOSFET réalisé dans une seconde portion (132b) de la seconde couche de semi-conducteur (132), une grille (128b) du second dispositif semi-conducteur (134) étant formée par au moins une seconde portion (128b) de la première couche métallique (128), et avec un diélectrique de grille (130b) disposée entre la grille (128b) et la seconde portion (132b) de la seconde couche de semi-conducteur (132),
la seconde couche de semi-conducteur (132) étant disposée sur une seconde couche diélectrique (146) empilée sur une seconde couche métallique (148).

2. Dispositif (1) selon la revendication 1, la première (118) et/ou la seconde (132) couche de semi-conducteur étant à base de silicium contraint.

3. Dispositif (1) selon l'une des revendications précédentes, le semi-conducteur de la première couche (118) ayant une orientation cristalline différente de celle du semi-conducteur de la seconde couche (132).

4. Dispositif (1) selon l'une des revendications précédentes, le semi-conducteur de l'une de la première (118) ou de la seconde (132) couche de semi-conducteur ayant une orientation cristalline égale à (100) et le semi-conducteur de l'autre de la première (118) ou de la seconde (132) couche ayant une orientation cristalline égale à *(110).*

5. Dispositif (1) selon l'une des revendications précédentes, l'un des premier (106) ou second (134) dispositif semi-conducteur de type MOSFET comportant un transistor PMOS et l'autre des premier (106) ou second (134) dispositif semi-conducteur de type MOSFET comportant un transistor NMOS.

6. Dispositif (1) selon la revendication 5, la première couche métallique (128) étant de type P lorsque le premier dispositif semi-conducteur (106) comporte un transistor NMOS, ou de type N lorsque le premier dispositif semi-conducteur (106) comporte un transistor PMOS, ou de type midgap.

7. Dispositif (1) selon l'une des revendications 5 ou 6, la seconde couche métallique (148) étant de type P lorsque le second dispositif semi-conducteur (134) comporte un transistor NMOS ou de type N lorsque le second dispositif semi-conducteur (134) comporte un transistor PMOS.

8. Dispositif (1) selon l'une des revendications précédentes, une grille (108) du premier dispositif semi-conducteur (106) étant à base d'un matériau différent du métal de la seconde couche métallique (148).

9. Dispositif (1) selon l'une des revendications précédentes, la première couche métallique (128) étant couplée à un premier contact électrique (129), la seconde couche métallique (148) étant couplée à un second contact électrique (152) indépendant du premier contact électrique (129).

10. Dispositif (1) selon l'une des revendications 1 à 8, la première couche métallique (128) et la seconde couche métallique (148) étant couplées à un premier contact électrique (129), la seconde couche métallique (148) étant couplée à un second contact électrique (152).

11. Dispositif (1) selon l'une des revendications précédentes, comportant en outre au moins une région diélectrique (154) séparant latéralement ladite région supérieure (102) de ladite région inférieure (104).

12. Dispositif (1) selon l'une des revendications précédentes, l'épaisseur de la première couche diélectrique (126) et/ou de la seconde couche diélectrique (146) étant inférieure ou égale à environ 20 nm.

13. Dispositif (1) selon l'une des revendications précédentes, une grille (108) du premier dispositif semi-conducteur (106) étant disposée sur une portion de diélectrique (109) dont la permittivité est supérieure à environ 3,9, la grille (128b) du second dispositif semi-conducteur (134) étant disposée sur un empilement de type oxyde-nitrure-oxyde.

14. Procédé de réalisation d'un dispositif (1) à MOSFET (106, 134) sur SOI, comprenant au moins les étapes de :
a) réalisation d'une structure formée d'une première couche de semi-conducteur (118) empilée sur une première couche diélectrique (126), une première couche métallique (128), une seconde couche de semi-conducteur (132), une seconde couche diélectrique (146) et une seconde couche métallique (148), et avec une troisième couche diélectrique (130) disposée entre la première couche métallique (128) et la seconde couche de semi-conducteur (132),
b) gravure d'une partie d'au moins la première couche de semi-conducteur (118) et la première couche diélectrique (126), mettant à nue une partie de la première couche métallique (128) et définissant des régions supérieure (102) et inférieure (104) du dispositif (1) à MOSFET sur SOI,
c) dépôt d'une quatrième couche diélectrique (109) et d'un matériau de grille (108) sur une partie non gravée de la première couche de semi-conducteur (118) au niveau de la partie supérieure (102) du dispositif (1) à MOSFET sur SOI,
d) gravure du matériau de grille (108), de la première couche métallique (128), et des troisième et quatrième couches diélectriques (109, 130), formant les grilles (108, 128b) et les diélectriques de grille (109, 130b) d'un premier et d'un second dispositif semi-conducteur (106, 134) de type MOSFET respectivement au niveau de la région supérieure (102) et de la région inférieure (104),
e) réalisation des zones de source (112, 136) et de drain (114, 138) des premier (106) et second (134) dispositifs semi-conducteur de type MOSFET, respectivement au niveau des régions supérieure (102) et inférieure (104).

15. Procédé selon la revendication 14, comportant en outre, après l'étape e), une étape de réalisation d'un premier contact électrique (129) couplé à la première couche métallique (128) et d'un second contact électrique (152) couplé à la seconde couche métallique (148), les deux contacts électriques (129, 152) étant indépendants l'un de l'autre ;

16. Procédé selon l'une des revendications 14 ou 15, comportant en outre, après l'étape e), une étape de réalisation d'un premier contact électrique (129) couplé à la première couche métallique (128) et à la seconde couche métallique (148), et d'un second contact électrique (152) couplé à la seconde couche métallique (148).

17. Procédé selon l'une des revendications 14 à 16, comportant en outre, après l'étape e), une étape de réalisation d'au moins une région diélectrique (154) séparant latéralement la région supérieure (102) de la région inférieure (104).

18. Procédé selon l'une des revendications 14 à 17, la réalisation de la structure, à l'étape a), comportant en outre la formation, par implantation d'ions et cuisson, dans la seconde couche à base de semi-conducteur (132), de zones (149) définissant les portions (132a, 132b) de la seconde couche de semi-conducteur (132) et pouvant être gravées sélectivement par rapport au semi-conducteur de ladite seconde couche (132), et comportant en outre, après l'étape d), une étape de gravure sélective de ces zones (149).

## Patentansprüche

1. SOI-MOSFET (106, 134) Vorrichtung (1), umfassend:
- einen oberen Bereich (102), umfassend mindestens eine erste Halbleitervorrichtung (106) vom MOSFET-Typ, die in einer ersten Halbleiterschicht (118) hergestellt ist, die auf eine erste dielektrische Schicht (126) gestapelt ist, einen ersten Abschnitt (128a) einer ersten metallischen Schicht (128) und einen ersten Abschnitt (132a) einer zweiten Halbleiterschicht (132), mit einer dielektrischen Gate-Schicht (109) und einem Gate-Material (108) auf der ersten Halbleiterschicht (118),
- einen unteren Bereich (104), umfassend mindestens eine zweite Halbleitervorrichtung (134) vom MOSFET-Typ, die in einem zweiten Abschnitt (132b) der zweiten Halbleiterschicht (132) hergestellt ist, wobei eine Gate-Elektrode (128b) der zweiten Halbleitervorrichtung (134) von mindestens einem zweiten Abschnitt (128b) der ersten metallischen Schicht (128) gebildet ist, mit einer dielektrischen Gate-Schicht (130b), die zwischen der Gate-Elektrode (128b) und dem zweiten Abschnitt (132b) der zweiten Halbleiterschicht (132) angeordnet ist, wobei die zweite Halbleiterschicht (132) auf einer zweiten dielektrischen Schicht (146) angeordnet ist, die auf eine zweite metallische Schicht (148) gestapelt ist.

2. Vorrichtung (1) nach Anspruch 1, wobei die erste (118) und/oder die zweite (132) Halbleiterschicht auf Basis von Zwangssilizium ist.

3. Vorrichtung (1) nach einem der vorhergehenden Ansprüche, wobei der Halbleiter der ersten Schicht (118) eine andere Kristallorientierung als jene des Halbleiters der zweiten Schicht (132) hat.

4. Vorrichtung (1) nach einem der vorhergehenden Ansprüche, wobei der Halbleiter einer der ersten (118) oder der zweiten (132) Halbleiterschicht eine Kristallorientierung gleich (100) und der Halbleiter der anderen de ersten (118) oder der zweiten (132) Schicht eine Kristallorientierung gleich *(110)* hat.

5. Vorrichtung (1) nach einem der vorhergehenden Ansprüche, wobei eine der ersten (106) oder zweiten (134) Halbleitervorrichtungen vom MOSFET-Typ einen PMOS-Transistor umfasst, und die andere der ersten (106) oder zweiten (134) Halbleitervorrichtungen vom MOSFET-Typ einen NMOS-Transistor umfasst.

6. Vorrichtung (1) nach Anspruch 5, wobei die erste metallische Schicht (128) vom Typ P ist, wenn die erste Halbleitervorrichtung (106) einen NMOS-Transistor umfasst, oder vom Typ N, wenn die erste Halbleitervorrichtung (106) einen PMOS-Transistor vom Midgap-Typ umfasst.

7. Vorrichtung (1) nach einem der Ansprüche 5 oder 6, wobei die zweite metallische Schicht (148) vom Typ P ist, wenn die zweite Halbleitervorrichtung (134) einen NMOS-Transistor umfasst, oder vom Typ N, wenn die zweite Halbleitervorrichtung (134) einen PMOS-Transistor umfasst.

8. Vorrichtung (1) nach einem der vorhergehenden Ansprüche, wobei eine Gate-Elektrode (108) der ersten Halbleitervorrichtung (106) auf Basis eines Materials ist, das sich von dem Metall der zweiten metallischen Schicht (148) unterscheidet.

9. Vorrichtung (1) nach einem der vorhergehenden Ansprüche, wobei die erste metallische Schicht (128) an einen ersten elektrischen Kontakt (129) gekoppelt ist, wobei die zweite metallische Schicht (148) an einen zweiten elektrischen Kontakt (152) gekoppelt ist, der von dem ersten elektrischen Kontakt (129) unabhängig ist.

10. Vorrichtung (1) nach einem der Ansprüche 1 bis 8, wobei die erste metallische Schicht (128) und die zweite metallische Schicht (148) an einen ersten elektrischen Kontakt (129) gekoppelt sind, wobei die zweite metallische Schicht (148) an einen zweiten elektrischen Kontakt (152) gekoppelt ist.

11. Vorrichtung (1) nach einem der vorhergehenden Ansprüche, ferner umfassend mindestens einen dielektrischen Bereich (154), der seitlich den oberen Bereich (102) vom unteren Bereich (104) trennt.

12. Vorrichtung (1) nach einem der vorhergehenden Ansprüche, wobei die dicke der ersten dielektrischen Schicht (126) und/oder der zweiten dielektrischen Schicht (146) kleiner oder gleich ungefähr 20 nm ist.

13. Vorrichtung (1) nach einem der vorhergehenden Ansprüche, wobei eine Gate-Elektrode (108) der ersten Halbleitervorrichtung (106) auf einem dielektrischen Abschnitt (109) angeordnet ist, dessen Dielektrizitätskonstante größer als ungefähr 3,9 ist, wobei die Gate-Elektrode (128b) der zweiten Halbleitervorrichtung (134) auf einem Stapel vom Typ Oxid-Nitrid-Oxid angeordnet ist.

14. Verfahren zur Herstellung einer SOI-MOSET (106, 134) Vorrichtung (1), umfassend mindestens die folgenden Schritte:
a) Herstellung einer Struktur, die von einer ersten Halbleiterschicht (118), die auf eine erste dielektrische Schicht (126) gestapelt ist, eine erste metallische Schicht (128), eine zweite Halbleiterschicht (132), eine zweite dielektrische Schicht (146) und eine zweite metallische Schicht (148), und mit einer dritten dielektrischen Schicht (130), die zwischen der ersten metallischen Schicht (128) und der zweiten Halbleiterschicht (132) angeordnet ist,
b) Gravur mindestens eines Teils der ersten Halbleiterschicht (118) und der ersten dielektrischen Schicht (126), die einen Teil der ersten metallischen Schichte (128) freilegt und obere (102) und untere (104) Bereiche der MOSFET-SOI Vorrichtung (1) definiert,
c) Aufbringen einer vierten dielektrischen Schicht (109) und eines Gate-Materials (108) auf einen nicht gravierten Teil der ersten Halbleiterschicht (118) im Bereich des oberen Teils (102) der MOSFET-SOI Vorrichtung (1),
d) Gravur des Gate-Materials (108), der ersten metallischen Schicht (128) und der dritten und vierten dielektrischen Schichten (109, 130), wobei die Gate-Elektroden (108, 128b) und die dielektrischen Gate-Schichten (109, 130b) einer ersten und einer zweiten Halbleitervorrichtung (106, 134) vom MOSFET-Typ im Bereich des oberen Bereichs (102) bzw. des unteren Bereichs (104) gebildet werden,
e) Herstellung der Source- (112, 136) und Drain-Zonen (114, 138) der ersten (106) und zweiten (134) MOSFET Halbleitervorrichtungen im Bereich der oberen (102) bzw. unteren Bereiche (104).

15. Verfahren nach Anspruch 14, ferner umfassend nach dem Schritt e) einen Schritt der Herstellung eines ersten elektrischen Kontakts (129), der an die erste metallische Schicht (128) gekoppelt ist, und eines zweiten elektrischen Kontakts (152), der an die zweite metallische Schicht (148) gekoppelt ist, wobei die zwei elektrischen Kontakte (129, 152) voneinander unabhängig sind.

16. Verfahren nach einem der Ansprüche 14 oder 15, ferner umfassend nach dem Schritt e) einen Schritt der Herstellung eines ersten elektrischen Kontakts (129), der an die erste metallische Schicht (128) und an die zweite metallische Schicht (148) gekoppelt ist, und eines zweiten elektrischen Kontakts (152), der an die zweite metallische Schicht (148) gekoppelt ist.

17. Verfahren nach einem der Ansprüche 14 bis 16, ferner umfassend nach dem Schritt e) einen Schritt der Herstellung mindestens eines dielektrischen Bereichs (154), der seitlich den oberen Bereich (102) vom unteren Bereich (104) trennt.

18. Verfahren nach einem der Ansprüche 14 bis 17, wobei die Herstellung der Struktur in Schritt a) ferner durch Implantieren von Ionen und Kochen in der Schicht auf Halbleiterbasis (132) die Bildung von Zonen (149) umfasst, die die Abschnitte (132a, 132b) der zweiten Halbleiterschicht (132) definieren und selektiv in Bezug zum Halbleiter der zweiten Schicht (132) graviert werden können, und ferner umfassend nach dem Schritt d) einen Schritt der selektiven Gravur dieser Zonen (149).

## Claims

1. MOSFET (106, 134) on SOI device (1), comprising:
- an upper region (102) comprising at least one first MOSFET type semiconductor device (106) formed in a first semiconductor layer (118) stacked on a first dielectric layer (126), a first portion (128a) of a first metallic layer (128) and a first portion (132a) of a second semi-conductor layer (132), and with a gate dielectric (109) and a gate material (108) on the first semiconductor layer (118),
- a lower region (104) comprising at least one second MOSFET type semi-conductor device (134) formed in a second portion (132b) of the second semi-conductor layer (132), a gate (128b) of the second semi-conductor device (134) being formed by at least a second portion (128b) of the first metallic layer (128), and with a gate dielectric (130b) arranged between the gate (128b) and the second portion (132b) of the second semiconductor layer (132),
the second semi-conductor layer (132)being arranged on a second dielectric layer (146) stacked on a second metallic layer (148).

2. Device (1) according to claim 1, the first (118) and/or the second (132) semiconductor layer comprise strained silicon.

3. Device (1) according to one of previous claims, the semiconductor of the first layer (118) having a crystalline orientation different to that of the semiconductor of the second layer (132).

4. Device (1) according to one of previous claims, the semiconductor of one of the first (118) or the second (132) semiconductor layers having a crystalline orientation equal to (100) and the semiconductor of the other of the first (118) or the second (132) layers having a crystalline orientation equal to *(110)*.

5. Device (1) according to one of previous claims, one of the first (106) or second (134) MOSFET type semiconductor devices comprising a PMOS transistor and the other of the first (106) or second (134) MOSFET type semiconductor devices comprising a NMOS transistor.

6. Device (1) according to claim 5, the first metallic layer (128) being P-type when the first semiconductor device (106) comprises a NMOS transistor, or N-type when the first semiconductor device (106) comprises a PMOS transistor, or of midgap type.

7. Device (1) according to one of claims 5 or 6, the second metallic layer (148) being P-type when the second semiconductor device (134) comprises a NMOS transistor or N-type when the second semiconductor device (134) comprises a PMOS transistor.

8. Device (1) according to one of previous claims, a gate (108) of the first semiconductor device (106) comprising a different material to the metal of the second metallic layer (148).

9. Device (1) according to one of previous claims, the first metallic layer (128) being coupled to a first electrical contact (129), the second metallic layer (148) being coupled to a second electrical contact (152) independent of the first electrical contact (129).

10. Device (1) according to one of claims 1 to 8, the first metallic layer (128) and the second metallic layer (148) being coupled to a first electrical contact (129), the second metallic layer (148) being coupled to a second electrical contact (152).

11. Device (1) according to one of previous claims, further comprising at least one dielectric region (154) laterally separating said upper region (102) from said lower region (104).

12. Device (1) according to one of previous claims, the thickness of the first dielectric layer (126) and/or of the second layer dielectric (146) being less than or equal to around 20 nm.

13. Device (1) according to one of previous claims, a gate (108) of the first semiconductor device (106) being arranged on a dielectric portion (109) whose permittivity is higher than around 3.9, the gate (128b) of the second semiconductor device (134) being arranged on an oxide-nitride-oxide type stacking.

14. Method of fabricating a MOSFET (106, 134) on SOI device (1), comprising at least the steps of:
a) fabricating a structure formed of a first semiconductor layer (118) stacked on a first dielectric layer (126), a first metallic layer (128), a second semiconductor layer (132), a second dielectric layer (146) and a second metallic layer (148), and with a third dielectric layer (130) arranged between the first metallic layer (128) and the second semiconductor layer (132),
b) etching of a part of at least the first semiconductor layer (118) and the first dielectric layer (126), laying bare a part of the first metallic layer (128) and defining upper (102) and lower (104) regions of the MOSFET on SOI device (1),
c) depositing a fourth dielectric layer (109) and a gate material (108) on a non-etched part of the first semiconductor layer (118) at the upper part (102) of the MOSFET on SOI device (1),
d) etching of the gate material (108), the first metallic layer (128), and the third and fourth dielectric layers (109, 130), forming the gates (108, 128b) of a first and a second MOSFET type semiconductor devices (106, 134) respectively at the upper region (102) and the lower region (104),
e) forming source (112, 136) and drain (114, 138) regions of the first (106) and second (134) MOSFET type semiconductor devices, respectively at the upper (102) and lower (104) regions.

15. Method according to claim 14, further comprising, after step e), a step of forming a first electrical contact (129) coupled to the first metallic layer (128) and a second electrical contact (152) coupled to the second metallic layer (148), the two electrical contacts (129, 152) being independent of each other.

16. Method according to one of claims 14 or 15, further comprising, after step e), a step of forming a first electrical contact (129) coupled to the first metallic layer (128) and to the second metallic layer (148), and a second electrical contact (152) coupled to the second metallic layer (148).

17. Method according to one of claims 14 to 16, further comprising, after step e), a step of forming at least one dielectric region (154) laterally separating the upper region (102) from the lower region (104).

18. Method according to one of claims 14 to 17, the formation of the structure, at step a), further comprising the formation, by ion implantation and annealing, in the second semiconductor based layer (132), zones (149) defining the portions (132a, 132b) of the second semiconductor layer (132) and that may be etched selectively compared to the semiconductor of said second layer (132), and further comprising, after step d), a step of selective etching of these zones (149).
